# EUROPEAN PATENT SPECIFICATION

(11) **EP 1 402 082 B1**
(45) Date of publication and mention of the grant of the patent: **02.02.2005**
(21) Application number: 02745799.3
(22) Date of filing: 21.06.2002
(51) Int. Cl.: C23C 14/56, C23C 14/24, C23C 14/26

(54) **APPARATUS FOR VACUUM VAPORIZATION**
VORRICHTUNG ZUR VAKUUMBEDAMPFUNG
APPAREIL DE VAPORISATION SOUS VIDE

(30) Priority: 03.07.2001 IT FI20010122
(43) Date of publication of application: 31.03.2004
(73) Proprietor: Galileo Vacuum Systems S.R.L., 59100 Prato (IT)
(72) Inventor: FUSI, Andrea, I-50136 Firenze (IT)
(74) Representative: Mannucci, Michele
(86) International application number: PCT/IT2002/000411
(87) International publication number: WO 2003/004720

(56) References cited:
- GB-A- 1 203 069
- US-A- 2 969 448
- US-A- 3 901 647
- PATENT ABSTRACTS OF JAPAN vol. 2000, no. 23, 10 February 2001 (2001-02-10) & JP 2001 172762 A (TOYOBO CO LTD), 26 June 2001 (2001-06-26)

## Description

### Technical field

This invention relates to equipment for the metal coating of a strip substrate, for example a film of plastic material on which a metal coating or the like has to be formed, by vacuum vaporization.

More particularly, the invention relates to vacuum vaporization equipment for the metal coating of a strip substrate of the type comprising:
- a plurality of vaporization sources heated and fed with a metal which is liquefied and vaporized by said sources,
- means for feeding said substrate over said sources, in the direction of feed, said source having an elongated body in the direction of feed,
- means for delivering metal wire to said sources.

The invention also relates to a vaporization source which can be used in an equipment of the aforesaid type.

### State of the art

Equipment for metal coating by vaporization in which a film or other substrate is unwound from a delivery spool, passed around a process roller and again wound onto a treated material spool are known for the vacuum metal coating of plastic films or other continuous strip substrates. In the zone in which the substrate is passed around the process roller it passes a number of vaporization sources which are located - together with at least part of the process roller - in a vacuum chamber in which a cloud of vaporized metal material from the source is formed. This metal material is deposited on the substrate by condensation, and the latter is then rewound onto the spool for treated material.

The process is a process of the batch type, in which individual spools of substrate requiring treatment are placed in the equipment, the equipment is sealed and placed under vacuum, the substrate is treated, and subsequently the spool of treated and wound substrate is removed from the equipment to be replaced by another spool of substrate requiring treatment

A description of the nature of the problems with such equipment can be found in G. Tonini, F. Grazzini, N. Merlini, "A New Generation of Film Metallizing" in Paper, Film and Foil Converter", February 1980.

The vaporization sources may have different configurations. These include vaporization sources of electrically conducting material which are heated by the direct passage of current, In this case the source is constructed in the form of a bar of conducting material, for example a ceramic or sintered metal powder material. The bar has a cavity forming a pit in which the well of molten metal which is vaporized by the heat of the source is formed. The metal is vaporized continuously and is continuously fed to the cavity in the source in the form of a wire which is unwound from a spool. A description of sources of this type can be found in, "Veredeln von Kunstoff-Oberflachen", by various authors, Carl Hanser Verlag, Munich, Vienna, 1974, pages 120 et seq., and in US-A-5,321,792.

One of the most difficult aspects of these sources and this equipment lies in the need to deposit extremely uniform metal coatings on the substrate which is moving above the sources. Special arrangements of the sources which tend to reduce lack of uniformity in the characteristics of the deposited layer as far as possible have been designed for this purpose.

A further critical aspect of vacuum metallizing equipment is the rate of production which can be achieved. This in fact depends on the quantity of metal which can be vaporized per unit time and therefore specifically on the size of the surface being vaporized. In directly heated sources, which have an elongated shape in the direction in which the substrate is fed and a cavity for the molten metal, it is in theory possible to increase the size of the cavity in plan to increase the surface area of evaporating metal. However, as a result of the surface tension in the liquid the molten metal lies in the cavity without fully filling it, but forming a well of circular or elliptical shape. As a consequence the vaporization surface area is less than the surface area of the cavity and cannot be increased. An increase in the number of vaporization sources however encounters a cost limit and a limit to the size of the sources.

One example of a special solution to the arrangement of sources is found in DE-A-402 7034. Here the sources are arranged alongside each other in a direction at right angles to the direction of advance of the strip substrate and are slightly offset with respect to each other in the direction in which the substrate advances.

### Objects and summary of the invention

The purpose of this invention is to provide vacuum metallizing equipment which makes it possible to increase the surface area of the evaporating liquid and therefore the quantity of metal evaporated while keeping the number of heating systems, that is sources, unchanged, and increasing the uniformity of the coating deposited on the substrate.

A further object of this invention is to provide direct heating sources which make it possible to increase the uniformity of the characteristics of the coating deposited on the substrate by vaporization under vacuum.

These and other objects and advantages which will be clear to those skilled in the art from a reading of the following text are substantially achieved through a vacuum vaporization equipment of the type mentioned above, in which each source has two cavities aligned along the direction in which the substrate is fed, and each of said two cavities is fed by a corresponding metal wire delivered from corresponding dispensing means. In this way the surface of the molten metal present in the vaporization source is physically subdivided into two parts. As a consequence more uniform filling of the two cavities is achieved, with the consequent formation of large evaporating surfaces. Although it is possible to envisage the use of a single cavity having a long longitudinal dimension which is fed by two metal wires at each end, in this case the two melting wires would form two adjacent wells of metal in the same cavity, wells which would touch each other in a wholly random way, for example as a result of the fall of drops of molten metal. Contact between the wells of molten metal in the same cavity could give rise to disturbances, and also to splashes of liquid metal onto the substrate, with consequent damage to the substrate. These disadvantages are avoided by physically subdividing the cavities into two, so that each well of metal is isolated from the other.

Subdivision of the evaporating zone into two cavities also has a further advantage: when a drop of metal falls onto the source to make up for the evaporated material it gives rise to disturbances due to the propagation of surface waves which affect an area equal to half the overall vaporizing surface area, with consequent greater uniformity in the deposition of metal onto the substrate.

Further advantageous features of the equipment and sources according to the invention are indicated in the appended claims.

### Brief description of the drawings

The invention will be better understood by following the description and appended drawing, which illustrates a non-restrictive embodiment of the invention. In the drawing
Figure 1 shows a diagrammatical side view of metallizing equipment,
Figure 2 shows a detail of a source and the corresponding metal wire feed means in side view,
Figures 3 and 4 show a view of a source according to the invention in longitudinal cross section and in plan along IV-IV in Figure 3, and
Figures 5 to 7 show diagrammatical views in plan of three possible arrangements of the sources within the equipment.

### Detailed description of the preferred embodiment of the invention

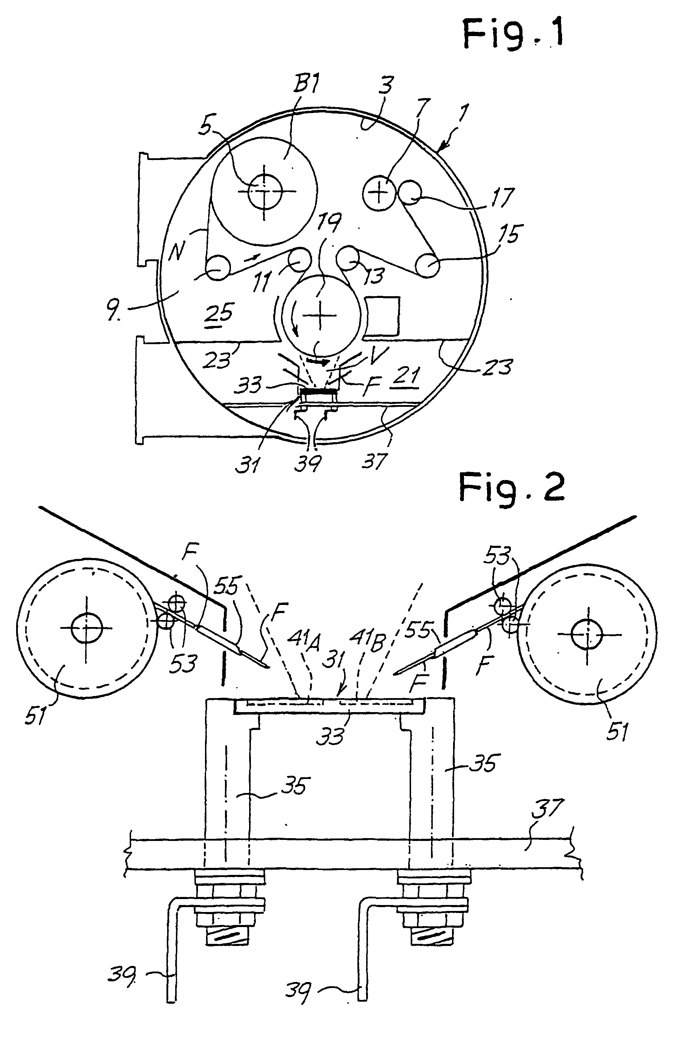

Figure 1 shows the interior of metallizing equipment for vacuum vaporization highly diagrammatically in side view.

This comprises a container 3 in which are located two supports 5 and 7 for the spools of the strip substrate which has to be metallized. A spool B1 of untreated substrate which is fed along a feed path defined by return rollers 9, 11, 13, 15, 17 is mounted on support 5. A second winding spool onto which the substrate is wound after metallization is located on support 7.

A process roller 19 of greater diameter which projects partly within a chamber 21 which is separated by means of a wall 23 from overlying chamber 25 in which supports 5 and 7 for the spools of substrate are located is positioned between roller 11 and roller 13. Chamber 21 is kept under higher vacuum than chamber 25. There are also units in which separating wall 23 and the subdivision into chambers 21 and 25 are not present. In this case the delivery spool, the winding spool, the path of substrate N, process roller 19 and the vaporization sources are all located in the same chamber.

Strip substrate N unwound from spool B1 and passed around Process roller 19 is gradually wound so as to form a spool of metallized substrate on support 7. While winding is in progress, in the path around process roller 19 a metal which is vaporized by a set of sources 31 which are located in chamber 21 beneath process roller 19 is deposited onto the surface of strip substrate N which is not in contact with process roller 19. V diagrammatically indicates the vaporized material issuing from sources 31, which are alongside each other in a direction at right angles to the direction FN in which substrate N advances, that is at right angles to the plane of the figure. As a result only one source can be seen in Figure 1.

The structure of the metallization equipment may vary and what is shown in Figure 1 is only a diagrammatical example of possible equipment in which the invention may be implemented.

Figure 2 shows a source 31 of the equipment in Figure 1 in magnified side view. This source comprises a bar 33 of electrically conducting material which is resistant to high temperatures, typically of the order of 1500°C. Bar 33 is also technically referred to as a boat. This is supported by two columns 35 which are of one piece with a supporting plate 37. Columns 35 are electrically conducting and are connected to two electrical conductors 39 through which a flow of current is caused to pass through boat 33, which as a result of the Joule effect dissipates heat, heating bar or boat 33.

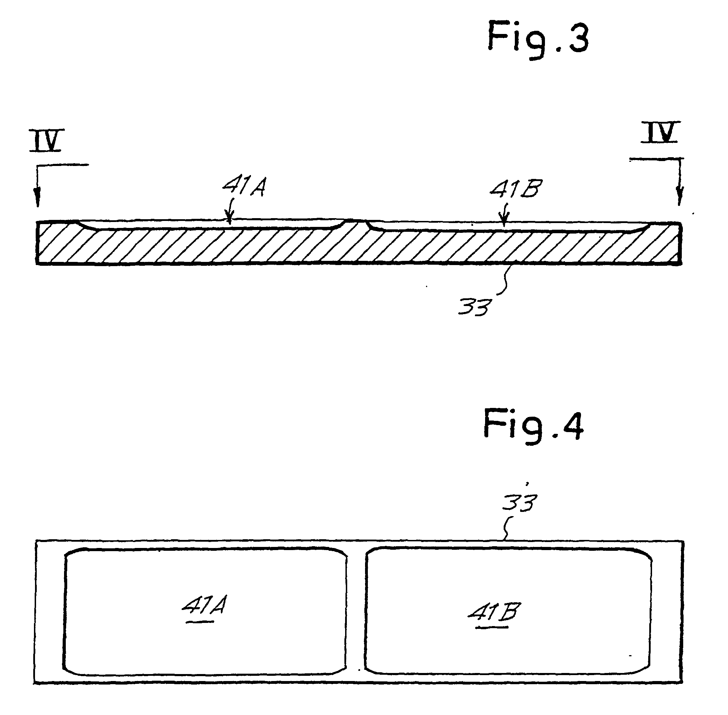

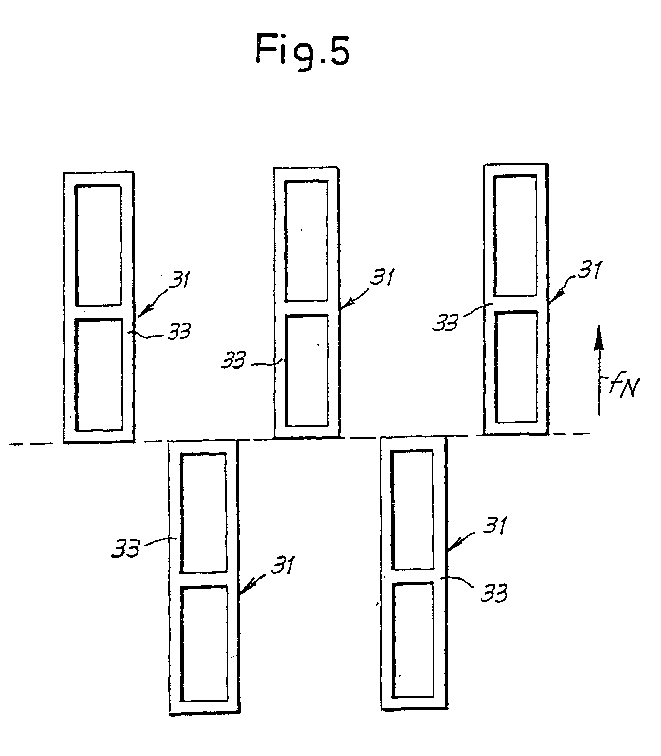

As shown in detail in Figures 3 and 4, bar or boat 33 in each source 31 has two shallow cavities 41A, 41B with a flat base and a substantially rectangular shape in plan (see Figure 4). Wells of liquefied metal which vaporize absorbing the heat generated by the Joule effect of the flow of current through bar or boat 33 form in these cavities 41A, 41B.

In order to maintain the desired level of liquid metal within cavities 41A, 41B and therefore to make up the metal which is delivered by the vaporization source, two separate means for the delivery of metal wire which is designed to be melted by heating by irradiation from part of bar 33 and to fall as drops into cavities 41 A and 41 B are provided.

The means for the delivery of the metal wire are illustrated diagrammatically in Figure 2 and may adopt various forms. These delivery means are of a type which are in themselves known and are not described in particular detail here. Diagrammatically in the example illustrated they comprise a reel 51 of metal wire F, a pair of small cylinders 53, at least one of which is motor-driven, for drawing metal wire F and unwinding it from reel 51 and feeding it through a guide tube 55. Metal wire F leaves tube 55 in a zone lying above corresponding cavity 41A or 41B.

The free end of wire F projecting from tube 55 melts gradually as a result of the heat produced by the current flowing in boat/bar 33. The drops of molten metal fall into the corresponding cavity and vaporize. Suitable systems, which are not shown and which are in themselves known, keep the necessary length of wire F projecting from tube 55 and control the gradual unwinding of wire F from reel 51 through small rollers 53.

The existence of two separate cavities on each bar or boat 33 and the feed provided to each of these by means of a separate metal wire has the result that disturbances induced by the drops of molten metal which fall into the wells formed in cavities 41A, 41B are reduced, thus contributing to uniformity of the coating on substrate M.

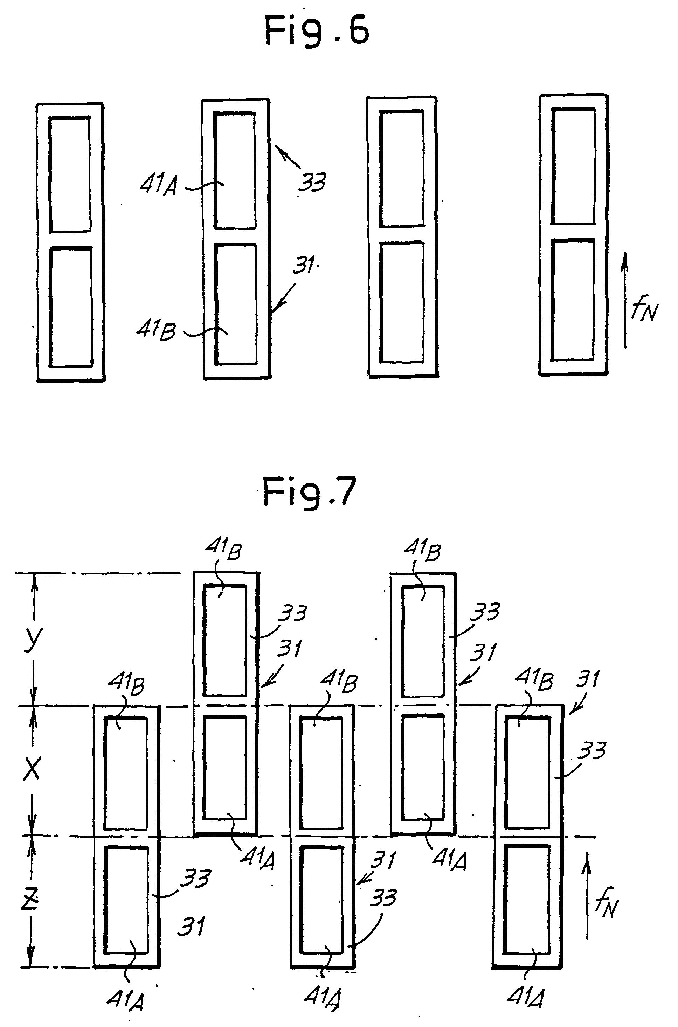

The various sources 31 may be alongside each other with their corresponding ends aligned along straight lines at right angles to the direction fN in which strip substrate N advances in front of the sources. An arrangement of this type is illustrated in Figure 6.

Vice versa, as is in itself known, sources 33 may be offset with respect to each other in the direction in which the strip substrate wound around process roller 19 advances. An arrangement of this type is illustrated for example in Figure 5, where some sources 31 (here, as in Figure 6, represented solely by corresponding bars 33) are in an offset arrangement in such a way that the overall zone affected by vaporization of the metal has a width equal to approximately twice the length of bars or boats 33. In this way mutual interference between the clouds of vaporized metal generated by various sources 31 is reduced.

Figure 7 illustrates an intermediate arrangement in which sources 33 are in an offset arrangement in such a way that all cavities 41B forming one vaporization strip X are in line, while cavities 41A of all the even-numbered sources are aligned in a strip Y and cavities 41A of the odd-numbered sources are aligned in a strip Z. This arrangement is equivalent to the addition of two adjacent rows of auxiliary sources to a row of conventional sources (represented by aligned cavities 41B) in which each comprises a number of sources equal to half the sources in the intermediate row. The two lateral rows (strips Y and Z) help to increase the quantity of metal deposited.

It should be understood that the drawing only illustrates an example embodiment of the invention, which may vary in shape and arrangement without however going beyond the scope of the basic concept of the invention.

## Claims

1. Vacuum vaporization equipment for metallizing a strip substrate, comprising:
- a plurality of vaporization sources which are heated and fed with a metal which is liquefied and vaporized by said sources,
- means for feeding said substrate over said sources along a feed direction, said source having a body which is elongated in the feed direction,
- means for the delivery of metal wire to said sources,
**characterized in that** each of said sources has two cavities aligned along the direction in which the substrate is fed, and that each of said two cavities is fed by a corresponding metal wire delivered by corresponding delivery means.

2. Equipment according to claim 1, **characterized in that** the two cavities of each source have a rectangular shape in plan which is elongated in the direction in which the substrate is fed.

3. Equipment according to claim 1 or 2, **characterized in that** the vaporization sources are made of electrically conducting material and are heated by the Joule effect as a result of the passage of current.

4. Equipment according to one or more of the foregoing claims. **characterized in that** the vaporization sources are alongside each other in an alignment transverse to the direction in which the substrate is fed.

5. Equipment according to claim 4, **characterized in that** the individual sources are offset with respect to each other along the direction in which the substrate is fed.

6. Equipment according to one or more of the foregoing claims, **characterized in that** said cavities have substantially flat bottoms.

7. Source for the vaporization of a metal under vacuum comprising an electrically conducting body which is elongated in a longitudinal direction, said body forming a continuous boat or bar with two opposite ends, **characterized in that** in said boat or bar a pair of cavities. are provided, arranged alongside each other in said longitudinal direction to form two wells of molten metal.

8. Source according to claim 7, **characterized in that** said cavities have a substantially rectangular shape in plan.

9. Source according to claim 7 or 8, **characterized in that** said cavities have substantially flat bottoms.

10. Source according to claim 7, 8 or 9, **characterized in that** it is made of electrically conducting material which is heated by the direct passage of current.

11. Source according to one or more of claims 7 to 10, **characterized in that** said body is made of a ceramic or sintered metal powder material.

## Patentansprüche

1. Vorrichtung zur Vakuumbedampfung zum Metallisieren eines Substratstreifens, mit:
- einer Anzahl von Verdampfungsquellen, die erhitzt werden und mit einem Metall beschickt werden, das durch die Quellen verflüssigt und verdampft wird,
- Mitteln zum Transportieren des Substrats über die Quellen entlang einer Transportrichtung, wobei die Quelle einen Körper hat, der in der Transportrichtung langgestreckt ist,
- Mitteln zum Zuführen des Metalldrahtes zu den Quellen,
**dadurch gekennzeichnet, dass** jede der Quellen zwei Hohlräume hat, die in der Richtung, in welcher das Substrat transportiert wird, fluchten, und dass jeder der zwei Hohlräume durch einen entsprechenden Metalldraht beschickt wird, der durch die entsprechenden Zuführmittel zugeführt wird.

2. Vorrichtung nach Anspruch 1, **dadurch gekennzeichnet, dass** die zwei Hohlräume in der Ebene eine rechteckige Form haben, die in der Richtung, in welcher das Substrat transportiert wird, langgestreckt ist.

3. Vorrichtung nach Anspruch 1 oder 2, **dadurch gekennzeichnet, dass** die Verdampfungsquellen aus elektrisch leitfähigem Material bestehen und als Ergebnis von Stromdurchgang durch den Joule-Effekt erhitzt werden.

4. Vorrichtung nach einem oder mehreren der vorstehenden Ansprüche,
**dadurch gekennzeichnet, dass** die Verdampfungsquellen längsseitig quer zu der Richtung, in der Substrat transportiert wird, zueinander fluchten.

5. Vorrichtung nach Anspruch 4, **dadurch gekennzeichnet, dass** die einzelnen Quellen in der Transportrichtung des Substrats zueinander versetzt sind.

6. Vorrichtung nach einem oder mehreren der vorstehenden Ansprüche,
**dadurch gekennzeichnet, dass** die Hohlräume im wesentlichen flache Böden haben.

7. Quelle zur Verdampfung eines Metalls unter Vakuum mit einem elektrisch leitfähigem Körper, der in einer Längsrichtung langgestreckt ist, wobei der Körper eine kontinuierliche Wanne oder einen Stab mit zwei einander gegenüberliegenden Enden bildet,
**dadurch gekennzeichnet, dass** in der Wanne oder dem Stab zwei Hohlräume vorgesehen sind, die in der Längsrichtung nacheinander angeordnet sind, um zwei Wannen mit geschmolzenem Metall zu bilden.

8. Quelle gemäß Anspruch 7, **dadurch gekennzeichnet, dass** die Hohlräume in der Ebene eine im wesentlichen rechteckige Form haben.

9. Quelle nach Anspruch 7 oder 8, **dadurch gekennzeichnet, dass** die Hohlräume im wesentlichen flache Böden haben.

10. Quelle gemäß Anspruch 7, 8 oder 9, **dadurch gekennzeichnet, dass** sie aus elektrisch leitfähigem Material besteht, das durch den direkten Durchgang von Strom erhitzt wird.

11. Quelle nach einem oder mehreren der Patentansprüche 7 bis 10,
**dadurch gekennzeichnet, dass** der Körper aus einer Keramik oder einem gesinterten Metallpulvermaterial besteht.

## Revendications

1. Appareil de vaporisation sous vide pour la métallisation d'un substrat en bande, comprenant :
- une pluralité de sources de vaporisation qui sont chauffées et alimentées par un métal qui est liquéfié et vaporisé par lesdites sources,
- des moyens pour alimenter ledit substrat au-dessus desdites sources le long d'une direction d'alimentation, ladite source ayant un corps qui est allongé dans la direction d'alimentation,
- des moyens pour l'amenée d'un fil métallique auxdites sources,
**caractérisé en ce que**, chacune desdites sources présente deux cavités alignées le long de la direction dans laquelle est alimenté le substrat, et **en ce que** chacune desdites deux cavités est alimentée par un fil métallique correspondant alimenté par des moyens d'alimentation correspondants.

2. Appareil selon la revendication 1, **caractérisé en ce que** les deux cavités de chaque source ont une forme rectangulaire en plan qui est allongée dans la direction dans laquelle est alimenté le substrat.

3. Appareil selon la revendication 1 ou 2, **caractérisé en ce que** les sources de vaporisation sont réalisées en un matériau conducteur électriquement et sont chauffées par effet Joule par suite du passage du courant.

4. Appareil selon une ou plusieurs des revendications précédentes, **caractérisé en ce que** les sources de vaporisation sont situées le long les unes des autres dans un alignement transversal à la direction dans laquelle est amené le substrat.

5. Appareil selon la revendication 4, **caractérisé en ce que** les sources individuelles sont décalées entre elles le long de la direction dans laquelle est amené le substrat.

6. Appareil selon une ou plusieurs des revendications précédentes, **caractérisé en ce que** lesdites cavités ont des fonds sensiblement plats.

7. Source pour la vaporisation d'un métal sous vide comprenant un corps conducteur électriquement qui est allongé dans une direction longitudinale, ledit corps formant une nacelle ou une barre continue avec deux extrémités opposées, **caractérisée en ce que** dans ladite nacelle ou barre est prévue une paire de cavités, le long l'une de l'autre dans ladite direction longitudinale pour former deux puits de métal fondu.

8. Source selon la revendication 7, **caractérisée en ce que** lesdites cavités ont une forme sensiblement rectangulaire dans le plan.

9. Source selon la revendication 7 ou 8, **caractérisée en ce que** lesdites cavités ont des fonds sensiblement plats.

10. Source selon la revendication 7, 8 ou 9, **caractérisée en ce qu'**elle est réalisée en un matériau électriquement conducteur qui est chauffé par le passage direct du courant.

11. Source selon une ou plusieurs des revendications 7 à 10, **caractérisée en ce que** ledit corps est réalisé en céramique ou en un matériau de poudre métallique frittée.
